(19) Europäisches Patentamt / European Patent Office / Office européen des brevets

(11) **EP 2 075 745 A1**

(12) **EUROPEAN PATENT APPLICATION**

(43) Date of publication:
**01.07.2009 Bulletin 2009/27**

(51) Int Cl.:
**G06N 1/00** (2006.01)

(21) Application number: **07124170.7**

(22) Date of filing: **28.12.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Hitachi Ltd.**
**Tokyo (JP)**

(72) Inventors:
• **Williams, David**
  **Cambridge, CB1 2EB (GB)**

• **Gorman, John**
  **Los Gatos, CA 95032 (US)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(54) **Quantum information processing device**

(57)    A quantum information processing device includes an isolated double quantum dot system ($902_1$), an electrometer ($903_1$) and an isolated conductive element ($901_1$) disposed between the isolated quantum dot system and the electrometer for coupling the isolated quantum dot system and the electrometer.

Fig. 20

EP 2 075 745 A1

**Description**

The present invention relates to a quantum information processing device.

Quantum information devices use quantum mechanical effects to store and process information in the form of quantum bits or "qubits". To operate efficiently, a quantum information device maintains a minimum degree of coherence while information is being processed. However, coherence is destroyed by, amongst other things, thermal noise. Thus, it is usually necessary to cool a quantum computer to cryogenic temperatures so as to minimise thermal noise.

EP-A-1262911 describes a quantum computer based on the distribution of an excess charge carrier on a pair of quantum dots. For example, if the excess charge carrier is on one dot, then the system is in a state $|0\rangle$. If the excess charge is on the other dot, then the system is in a state $|1\rangle$. The quantum dots are arranged in series in a channel between a source and drain, herein referred to as the "leads". Each quantum dot is separated from one of the leads and from the other quantum dot by respective controllable tunnel barriers. Using Coulomb blockade and the controllable tunnel barriers, a charge carrier can be selectively introduced from a lead onto one of the quantum dots, thus preparing the system in a given state, for example $|0\rangle$. Thereafter, the quantum dots can be electrically isolated from the leads, but allowed to interact with each other for a given duration of time during which the initial state is transformed into a superposition of $|0\rangle$ and $|1\rangle$ states. The final state of the system can be read by measuring charge on one or the other quantum dot.

A drawback of this type of quantum computer is that the leads are directly connected to cables and equipment, which are at room temperature, i.e. at around 290 °K. Thus, the leads provide significant sources of noise which are directly coupled to the quantum dots and thus cause errors during operation of the quantum computer.

A solution to this problem is to remove direct coupling of the quantum dots from their leads and to carry out operations only through capacitive coupling as described in "Isolated double quantum dot capacitively coupled to a single quantum dot single-electron transistor in silicon" by E. G. Emiroglu, D. G. Hasko and D. A. Williams, Applied Physics Letters, volume 83, page 3942 (2003).

Such an isolated double quantum dot can be used to provide a charge qubit which can be initialized and manipulated using capacitively-coupled gates and measured using a capacitively coupled single-electron transistor, as described in "Charge-Qubit Operation of an Isolated Double Quantum Dot", J. Gorman, D. G. Hasko and D. A. Williams, Physical Review Letters, volume 95, page 090502 (2005).

According to a first aspect of the present invention the is provided a quantum information processing device including an isolated double quantum dot system, an electrometer and an isolated conductive element disposed between the isolated quantum dot system and the electrometer for coupling the isolated quantum dot system and the electrometer.

The isolated conductive element can help to reduce further noise and, thus, maintain coherence in the isolated double quantum dot system for longer and/or can be used for additional quantum information processing.

The isolated conductive element may comprise a region of semiconducting material, such as silicon. The semiconducting material may be intrinsic or may be doped with an impurity having an impurity concentration of at least $1\times10^{18}$ cm$^{-3}$.

The isolated conductive element may be arranged as an elongate bar.

The isolated conductive element may be arranged to exhibit Coulomb blockade and may exhibit quantised states.

The isolated conductive element may be formed in a layer having a thickness equal to or less than about 100 nm, preferably equal to or less than about 50 nm. The isolated conductive element may be elongate and has a longitudinal dimension equal to or less than about 100 nm. The isolated conductive element may be elongate and has a first, transverse dimension equal to or less than about 50 nm. The isolated conductive element may be elongate and has a second, transverse dimension equal to or less than about 50 nm. The second, transverse dimension may correspond to a layer thickness.

The isolated double quantum dot system and the isolated conductive element may be separated by a gap equal to or less than about 500 nm or equal to or more than about 10 nm, preferably between about 200 to 300 nm. The isolated double quantum dot system and the isolated conductive element may be separated by a gap equal to or more than about 20 nm, preferably equal to or more than about 40 nm. The electrometer and the isolated conductive element may be separated by a gap equal to or less than about 200 nm, preferably equal to or less than about 100 nm. The isolated double quantum dot system and the isolated conductive element may be separated by a gap equal to or more than about 20 nm, preferably equal to or more than about 40 nm.

The isolated double quantum dot system may comprise a region of semiconducting material, such as silicon. The semiconducting material may be intrinsic or may be doped with an impurity having an impurity concentration of at least $1\times10^{18}$ cm$^{-3}$.

The isolated conductive element may be arranged to exhibit Coulomb blockade. The isolated conductive element may be a double quantum dot system.

The device may comprise an array of isolated double quantum dot systems and at least one electrometer for determining charge distribution on at least one isolated double quantum dot system.

Each isolated double quantum dot system may be bilobate having first and second lobes.

Isolated double quantum dot systems which are adjacent to each other in a row or column may be arranged perpendicularly to each other.

Isolated double quantum dot systems which are adjacent to each other in a row may be arranged perpendicularly to each other and isolated double quantum dot systems which are adjacent to each other in a column are arranged in parallel or *vice versa.*

According to a second aspect of the present invention there is provided apparatus comprising the device, a radio frequency signal source and an antenna coupled to the source, the source and antenna arranged so as to excite the or each isolated double quantum dot system.

According to a third aspect of the present invention there is provided apparatus comprising the device a refrigerator for cooling the device to a temperature equal to or less than 4.2 °K.

Embodiments of the present invention will now be described by way of example with reference to the accompanying drawings in which:

Figure 1 is a plan view of an isolated double quantum dot device;

Figure 2 is a cross section of the device taken along the line A-A' in Figure 1;

Figure 3 illustrates quantum dots within the device shown in Figure 1.

Figure 4 shows an equivalence circuit for the device shown in Figure 1;

Figures 5a and 5b illustrate a double potential well system in the absence and presence respectively of an applied electric field;

Figure 6 is a scanning electron micrograph of the device shown in Figure 1;

Figures 7a and 7b are grey-scale conductance plots for the device shown in Figure 1 obtained by sweeping $V_{DS}$ at different transistor gate voltages $V_{G4}$ and gate voltages $V_{G2}$;

Figure 8 includes first, second and third plots of source-drain current $I_D$ against gate voltage $V_{G2}$ for different transistor gate voltages $V_{G4}$;

Figures 9a to 9d are cross sectional views of the device shown in Figure 1 at different stages during fabrication;

Figure 10a to 10d are plan views of the device shown in Figure 1 at different stages during fabrication;

Figure 11 is a plan view of a first device in accordance with the present invention;

Figure 12 is a scanning electron micrograph of the device shown in Figure 11;

Figure 13 is a plan view of a second device in accordance with the present invention;

Figure 14 is a plan view of a third device in accordance with the present invention;

Figure 15 is a plan view of a fourth device in accordance with the present invention;

Figure 16 is a plan view of a fifth device in accordance with the present invention;

Figure 17 is a plan view of a sixth device in accordance with the present invention;

Figure 18 is a plan view of a seventh device in accordance with the present invention;

Figure 19 is a plan view of an eighth device in accordance with the present invention; and

Figure 20 is a plan view of an ninth device in accordance with the present invention.

Isolated quantum dot device 1

*Device layout*

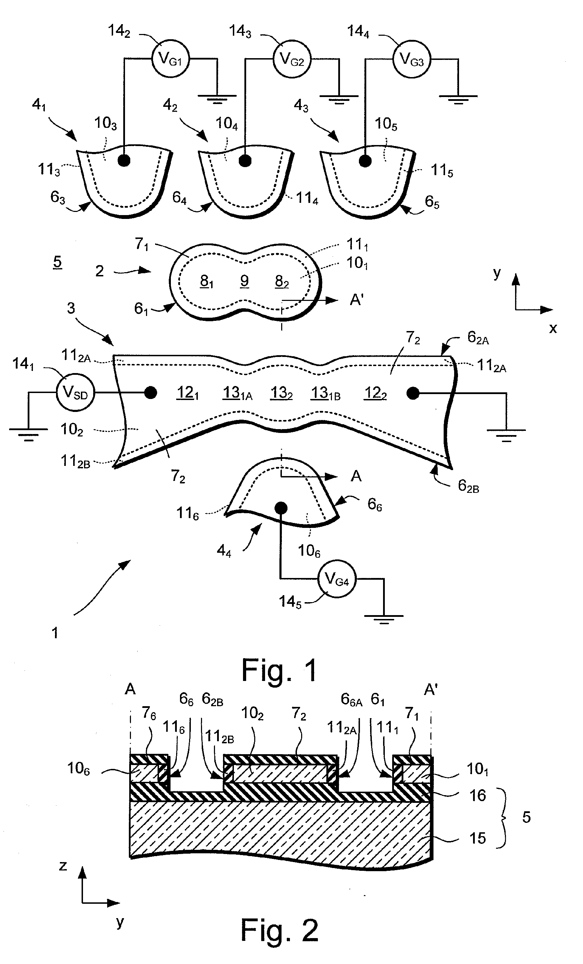

Referring to Figures 1 and 2, an isolated quantum dot device 1 is shown.

The isolated quantum dot device 1 comprises an isolated double quantum dot system 2 capacitively coupled to a single electron transistor 3. The device 1 also includes a plurality of side gates $4_1$, $4_2$, $4_3$, $4_4$ for controlling operation of the isolated quantum dot system 2 and single electron transistor 3.

The isolated quantum dot system 2, single electron transistor 3 and side gates $4_1$, $4_2$, $4_3$, $4_4$ are upstanding from a substrate 5, defined by sidewalls $6_1$, $6_{2A}$, $6_{2B}$, $6_3$, $6_4$, $6_5$, $6_6$ and capped by insulating regions $7_1$, $7_2$, $7_3$, $7_4$, $7_5$, $7_6$.

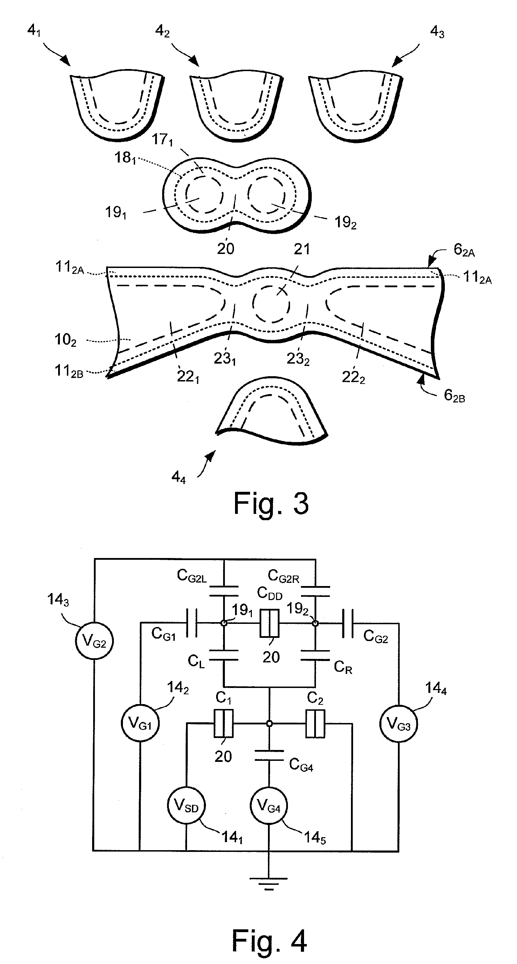

A first sidewall $6_1$ defines the isolated double quantum dot system 2 which comprises first and second lobe regions $8_1$, $8_2$ and a connecting region 9 for forming first and second quantum dots $19_1$, $19_2$ (Figure 3) and a tunnel barrier 20 (Figure 3). A conducting region $10_1$ lies beneath the capping insulating region $7_1$ and runs from the first lobe region $8_1$, through the connecting region 9, to the second lobe region $8_2$. An insulating region $11_1$ also lies beneath the capping insulating region $7_1$ and borders the conducting region $10_1$. The insulating region $11_1$, together with the capping insulating region $7_1$ and an underlying insulating region 16 (Figure 2) encapsulates the conducting region $10_1$ in the isolated quantum dot system 2.

In plan view, the first and second lobe regions $8_1$, $8_2$ appear as intersecting oval regions. However, other lobed arrangements, such as a dumb-bell arrangement in which the relatively wide first and second lobe regions $8_1$, $8_2$ are separated by a relatively narrow elongated connecting region 10, may be used. The lobe regions $8_1$, $8_2$ need not be

oval, but can be circular or polygonal in plan view.

An isolated quantum dot system 2 having one quantum dot, three quantum dots or more than three quantum dots may be defined. As will be described later, an isolated double quantum dot system can operate as a quantum information processing system using a charge qubit. The system can operate as a quantum information processing device using a spin qubit. An isolated quantum dot system having three or more quantum dots can operate as a quantum computer using one or more charge qubits.

The system 2 may be asymmetric. For example one lobe region may have a diameter d and the other lobe region may have a diameter of up to about 1.5d.

The system 2 is arranged such that first and second quantum dots $19_1$, $19_2$ (Figure 3) are formed in the conducting region $10_1$ and separated by a tunnel barrier 20 (Figure 3). The system 2 and its characteristics will be described in more detail later.

The first and second lobe regions $8_1$, $8_2$ each have a diameter of about 40 nm. However, the first and second lobe regions $8_1$, $8_2$ may have a diameter between 30 and 70 nm. The width and length of the connecting region 9 are each about 20 nm. Thus, the system 2 is about 40 nm wide and about 100 nm long.

The dimensions of the regions $8_1$, $8_2$, 9 may be the order of 1 nm, 10 nm or even 100 nm. Routine experiments may be conducted to determine the dimensions of the regions $8_1$, $8_2$, 9. Generally, larger lobe regions $8_1$, $8_2$ provide more closely-spaced quantum energy levels and charging energy levels and, thus, the operating temperature of the device becomes lower. Routine experiments may also be conducted to determine the dimensions of the connecting region 9. Generally, narrower and/or longer the connecting region 9 provide(s) a higher barrier resistance. The connecting region 9 is usually arranged such that its resistance exceeds the quantum resistance $R_K$ but is not so high that tunnelling between the quantum dots $19_1$, $19_2$ become difficult even at high applied fields. The width and length of the connecting region 9 need not be equal.

A second sidewall $6_{2A}$, $6_{2B}$ defines the single electron transistor 3 which comprises source and drain regions $12_1$, $12_2$ and a channel region $13_{1A}$, $13_{1B}$, $13_2$. A conducting region $10_2$ lies beneath the insulating region $7_2$ and runs from the source region $12_1$, through the channel region $13_{1A}$, $13_{1B}$, $13_2$, to the drain region $12_2$. An insulating region $11_{2A}$, $11_{2B}$ also lies beneath the insulating region $7_2$ and borders the conducting region $10_2$ along sidewall $6_{2A}$, $6_{2B}$ having a portion $6_{2A}$ which is generally near to and a portion $6_{2B}$ which is generally far from the isolated quantum dot system 2. The sidewall portions $6_{2A}$, $6_{2B}$ are part of the same sidewall and the insulating region portions $11_{2A}$, $11_{2B}$ are connected to form a continuous insulating region. However, separate sidewalls and separate insulating regions may be defined.

In plan view, the source and drain regions $12_1$, $12_2$ are initially splayed, being narrower at the channel $13_{1A}$, $13_{1B}$, $13_2$ and becoming wider further away. The channel region $13_{1A}$, $13_{1B}$, $13_2$ is laterally "pinched" so as to produce first and second narrow channel portions $13_{1A}$, $13_{1B}$ and an intermediate wide channel portion $13_2$. Other channel region $13_{1A}$, $13_{1B}$, $13_2$ arrangements may be used. For example, the channel region 13 may be arranged as a so-called "nanowire" having substantially uniform width along its length.

The single electron transistor 3 is arranged such that a third quantum dot 21 (Figure 3) is formed in the conductive region $10_2$ in the wide channel portion $13_2$ and first and second tunnel barriers $23_1$, $23_2$ (Figure 3) are formed in the first and second narrow channel portions $13_{1A}$, $13_{1A}$ respectively. The quantum dot 21 is configured such that it exhibits charging effects, i.e. Coulomb blockade. The single electron transistor 3 may be arranged, for example, using a nanowire, such that plural quantum dots (not shown) and plural tunnel barriers (not shown) are defined, which are formed alternately along the conductive region $10_2$.

The wide channel portion $13_2$ has a width and length of about 40 nm. The width and length of the narrow channel portions $13_{1A}$, $13_{1B}$ are about 20 nm. However, the widths and lengths need not be equal. The dimensions of the narrow and wide channel regions $13_{1A}$, $13_{1B}$, $13_2$ may be the order of 1 nm, 10 nm or even 100 nm. Routine experiments may be used to determine the dimensions of the channel $13_{1A}$, $13_{1B}$, $13_2$.

The single electron transistor 3 is arranged along one side of the isolated dot system 2 such that the wide channel portion $13_2$ is closer to the second lobe region $8_2$ than it is to the first lobe region $8_1$ or *vice versa*. Thus, the single electron transistor 3 may be used to detect polarization of the isolated dot system 2. The wider channel portion $13_2$ and the second lobe region $8_2$ are separated by about 80 nm.

A second single electron transistor (not shown) may be provided. If two single electron transistors are provided, one transistor can be configured to detect charge in one lobe region $8_1$ and the other transistor can be configured to detect charge in the other lobe region $8_2$.

Third, fourth, fifth and sixth sidewalls $6_3$, $6_4$, $6_5$, $6_6$ define first, second, third and fourth side gates $4_1$, $4_2$, $4_3$, $4_4$ respectively. Conducting regions $10_3$, $10_4$, $10_5$, $10_6$ lie beneath insulating regions $7_3$, $7_4$, $7_5$, $7_6$ respectively. Insulating regions $11_3$, $11_4$, $11_5$, $11_6$ also lie beneath insulating regions $7_3$, $7_4$, $7_5$, $7_6$ respective and border corresponding conducting regions $10_3$, $10_4$, $10_5$, $10_6$ along sidewalls $6_3$, $6_4$, $6_5$, $6_6$.

In plan view, the side gates $4_1$, $4_2$, $4_3$, $4_4$ appear as fingers.

First, second and third side gates $4_1$, $4_2$, $4_3$ are arranged in a row along one side of the isolated dot system 2.

The second side gate $4_2$ is arranged to be substantially equidistant from the first and second lobes $8_1$, $8_2$. The first and third side gates $4_1$, $4_3$ are arranged on either side of the second side gate $4_2$ and arranged to be closer to the first and second lobes $8_1$, $8_2$ respectively.

The gates $4_1$, $4_2$, $4_3$ are arranged such that the second gate $4_2$ may be used to control coupling between the first and second quantum dots $19_1$, $19_2$ (Figure 3), while the first and third side gates $4_1$, $4_3$ may be used to apply an electric field, E, so as to polarise the isolated dot system 2. Thus, the first, second and third side gates $4_1$, $4_2$, $4_3$ may be arranged differently to achieve or contribute towards these functions. The gates $4_1$, $4_2$, $4_3$ and the isolated quantum dot system 2 are separated by about 40 nm (along the y-axis).

Fourth side gate $4_4$ is arranged along side the wide channel portion $13_2$ of the single electron transistor 3 on the far side from the isolated dot system 2.

The gate $4_4$ is arranged to induce charge on the quantum dot 20 (Figure 3) of the single electron transistor 3 and thus control current flow. Thus, the wide channel portion $13_2$ is disposed between the second lobe $8_2$ of the isolated dot system 2 and the fourth side gate $4_4$. Thus, the fourth gate $4_4$ may be arranged differently to achieve or contribute towards this function. The gate $4_4$ and the wider channel portion $13_2$ are separated by about 40 nm.

The capping insulating regions $7_1$, $7_2$, $7_3$, $7_4$, $7_5$, $7_6$ are formed of silicon dioxide ($SiO_2$) and have a thickness of about 20 nm. The conducting regions $10_1$, $10_2$ $10_3$, $10_4$, $10_5$ $10_6$ are formed of n-type, polycrystalline silicon (Si) doped with phosphorous (P) to a concentration of $2.9 \times 10^{19} cm^{-3}$ and have a thickness of about 40 nm. The insulating regions $11_1$, $11_{2A}$, $11_{2B}$, $11_3$, $11_4$, $11_5$, $11_6$ are formed of silicon dioxide ($SiO_2$) and have a thickness of about 40 nm. The conducting regions $10_1$, $10_2$ $10_3$, $10_4$, $10_5$ $10_6$ need not be doped, but can be intrinsic, for example having a background impurity concentration of less than or equal to about $10^{15} cm^{-3}$.

Conducting regions $10_1$, $10_2$ $10_3$, $10_4$, $10_5$ $10_6$ formed of Si may be doped with other n-type impurities or a p-type impurity and to a concentration of the order of $10^{18} cm^{-3}$, $10^{19} cm^{-3}$ or $10^{20} cm^{-3}$. The insulating regions $11_1$, $11_{2A}$, $11_{2B}$, $11_3$, $11_4$, $11_5$, $11_6$ may be formed from other insulating materials, such as silicon nitride ($Si_xN_y$).

The conducting region regions $10_1$, $10_1$ $10_3$, $10_4$, $10_5$ $10_6$ may comprise other doped semiconductor materials such as silicon-germanium (SiGe) or binary or tertiary materials, for instance gallium arsenide (GaAs). For example, the conducting region regions $10_1$, $10_2$ $10_3$, $10_4$, $10_5$ $10_6$ may comprise intrinsic GaAs, $n^-$ GaAs, $n^+$ GaAs or $\delta$-doped GaAs and, if so, the insulating regions $11_1$, $11_{2A}$, $11_{2B}$, $11_3$, $11_4$, $11_5$, $11_6$ may be formed from intrinsic GaAs or aluminium gallium arsenide (AlGaAs).

A first voltage source $14_1$ is used to apply a bias $V_{SD}$ between source and drain $12_1$, $12_2$. Second, third, fourth and fifth voltage sources $14_2$, $14_3$, $14_4$, $14_5$ are used to apply a gate biases $V_{G1}$, $V_{G2}$, $V_{G3}$, $V_{G4}$ to the first, second, third and fourth gates $4_1$, $4_2$, $4_3$, $4_4$ respectively.

Referring to Figure 2, the isolated quantum dot system 2, single electron transistor 3 and side gates $4_1$, $4_2$, $4_3$, $4_4$ are upstanding from the substrate 5 which comprises a silicon substrate 15 and an overlying, partially etched silicon dioxide layer 16.

Referring to Figure 3, depletion regions $17_1$, $17_{2A}$, $17_{2B}$, $17_3$, $17_4$, $17_5$, $17_6$ extend laterally into the conducting regions $10_1$, $10_2$ $10_3$, $10_4$, $10_5$ $10_6$ from respective interfaces $18_1$, $18_{2A}$, $18_{2B}$, $18_3$, $18_4$, $18_5$, $18_6$ between the conducting regions $10_1$, $10_2$ $10_3$, $10_4$, $10_5$ $10_6$ and the insulating regions $11_1$, $11_{2A}$, $11_{2B}$, $11_3$, $11_4$, $11_5$, $11_6$. Depletion regions (not shown) also extend vertically from interfaces between the conducting regions $10_1$, $10_2$ $10_3$, $10_4$, $10_5$ $10_6$ and the capping and underlying insulating regions $7_1$, $7_2$, $7_3$, $7_4$, $7_5$, $7_6$, 16. The depletion region is about 11 nm wide. The deletion region may be thinner, even negligible, or may be thicker.

In the isolated dot system 2, the depletion region $17_1$ extends into the conducting region $10_1$ from facing portions of the interface $18_1$ in the connecting region 9 to such an extent that first and second quantum dots $19_1$, $19_2$ are formed separated by a tunnel barrier region 20.

Likewise, in the single electron transistor 3, the depletion region $17_{2A}$, $17_{2B}$ extends sufficiently far into the conducting region $10_2$ from facing portions of the interface $18_{2A}$, $18_{2B}$ in the narrow channel portions $13_{1A}$, $13_{1B}$ that a third quantum dot 21 is formed separated from undepleted source and drain regions $22_1$, $22_2$ by tunnel barrier regions $23_1$, $23_2$.

The side gates $4_1$, $4_2$, $4_3$, $4_4$ each comprise an undepleted conducing region $24_1$, $24_2$, $24_3$, $24_4$.

Referring to Figure 4, a simplified circuit diagram of the isolated quantum dot device 1 is shown. The isolated quantum dot device 1 may be modelled using the following coupling capacitances listed in Table 1 below:

Table 1

| Regions coupled by capacitance | Capacitance |
|---|---|
| First quantum dot $19_1$ & second quantum dot $19_2$ | $C_{DD}$ |
| First quantum dot $19_1$ & first side gate $4_1$ | $C_{G1}$ |
| First quantum dot $19_1$ & second side gate $4_2$ | $C_{G2L}$ |

(continued)

| Regions coupled by capacitance | Capacitance |
|---|---|
| First quantum dot $19_1$ & third quantum dot 20 | $C_L$ |
| Second quantum dot $19_1$ & second side gate $4_2$ | $C_{G2R}$ |
| Second quantum dot $19_1$ & third side gate $4_3$ | $C_{G3}$ |
| Second quantum dot $19_1$ & third quantum dot 20 | $C_R$ |
| Third quantum dot 20 & source region $22_1$ | $C_1$ |
| Third quantum dot 20 & drain region $22_2$ | $C_2$ |

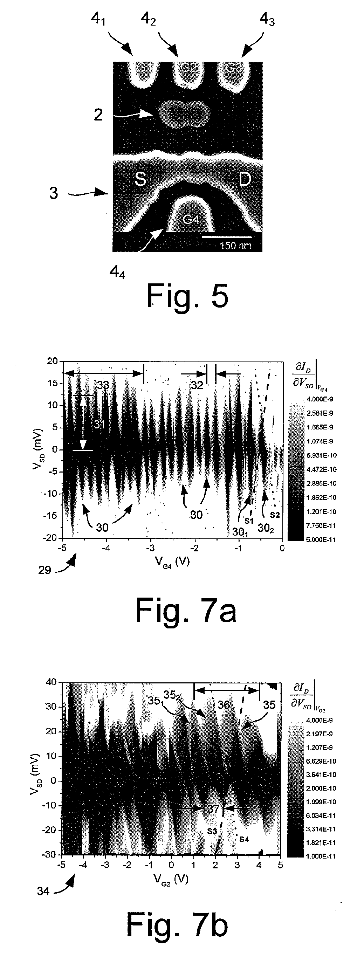

Referring to Figure 5, a scanning electron micrograph of the isolated quantum dot device 1 is shown.

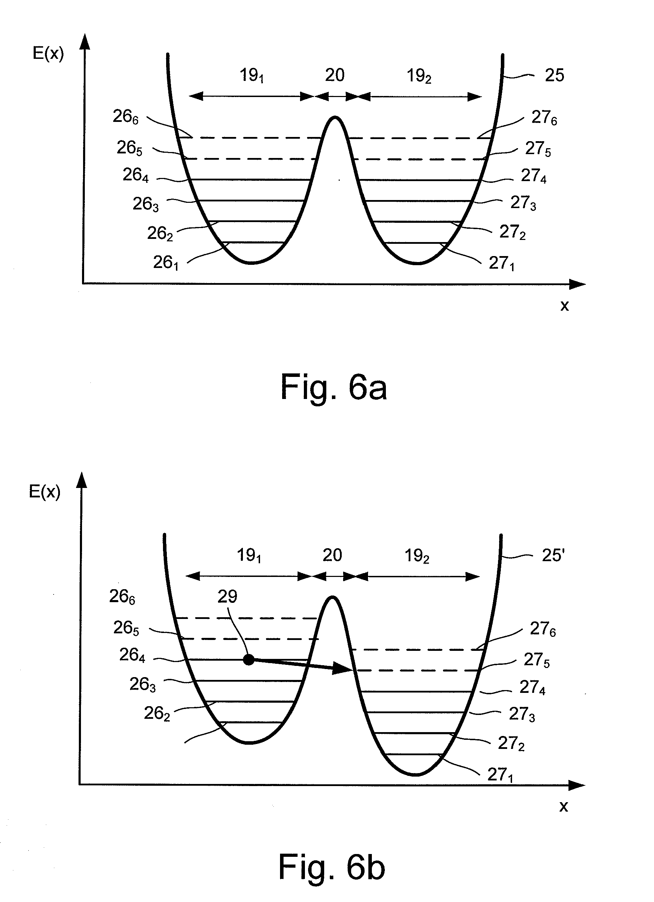

Referring to Figures 6a and 6b, simplified energy diagrams of the isolated dot system 2 in a ground state and a polarised state are shown.

The first and second quantum dots $19_1$, $19_2$ and the tunnel barrier 20 can be represented as an infinite double well potential 25. Each quantum dot $19_1$, $19_2$ includes a set of occupied states $26_1$, $26_2$, $26_3$, $26_4$, $27_1$, $27_2$, $27_3$, $27_4$ and available states $26_5$, $26_6$, $27_5$, $27_6$.

In a ground state, the double well potential 25 is symmetric and the quantum dots $19_1$, $19_2$ have equal numbers of occupied states $26_1$, $26_2$, $26_3$, $26_4$, $27_1$, $27_2$, $27_3$, $27_4$ with highest occupied states $26_4$, $27_4$ having substantially the same energy. However, the double well potential 25 may be asymmetric in a ground state.

As will be explained in more detail later, the first and third side gates $4_1$, $4_2$ (Figure 1) can be used to apply an electric field E having a component, in this case $E_x$, aligned along an axis, in this case the x-axis, passing through the centres of the quantum dots $19_1$, $19_2$ so as to polarise the isolated dot system 2.

In a polarised state, the double well potential 25' is asymmetric and, if the electric field E is high enough, a charge carrier, in this case an electron 28, tunnels from an occupied state $26_4$ of one quantum well $19_1$ through the tunnel barrier 20 to an unoccupied state $27_5$ the other quantum well $19_2$.

If the electric field E is removed, then the isolated dot system 2 may remain polarised for a given time t or even longer. This may occur due to Coulomb blockade. However, as will be described in more detail later, the second side gate $4_2$ (Figure 1) can be used to apply an electric field so as to lower the tunnel barrier 20 and thus permit the electron to tunnel back.

*Electrical characteristics*

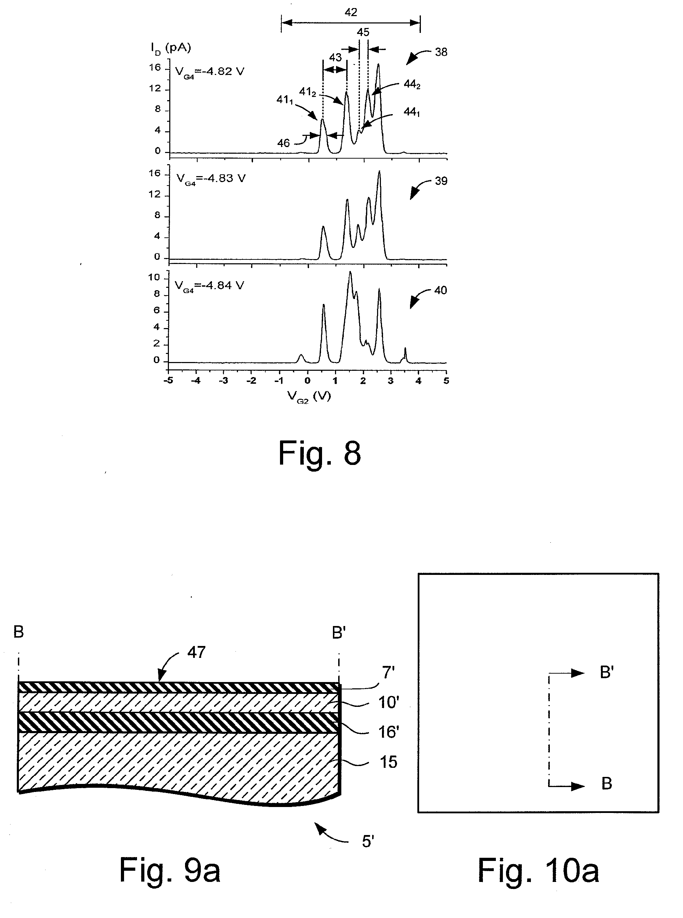

Referring to Figures 7a, 7b and 8, electrical characteristics of the device 1 will now be described:

The properties of the isolated quantum dot system 2 (Figure 1) are not measured using direct transport measurements. Instead, the isolated quantum dot system 2 is characterized through stability diagrams of the single electron transistor 3, which is capacitively coupled to it, as a function of the potentials on side gates $4_1$, $4_2$, $4_3$, $4_4$.

In Figure 7a, a first stability diagram in the form of a grey-scale conductance plot 29 is shown. The plot 29 shows measured conductance $\partial I_D/\partial V_{SD}$ as a function of source-drain bias $V_{SD}$ and fourth gate bias $V_{G4}$ on a logarithmic scale. Different fixed biases are applied to the fourth gate $4_4$ ranging from -5 to 0 V. While a given fixed bias $V_{G4}$ is applied to the fourth gate $4_4$ and the other gates $4_1$, $4_2$, $4_3$ are grounded, a bias $V_{SD}$ applied between the source and drain regions $12_1$, $12_2$ (Figure 1) is swept. Measurements are taken while the isolated quantum dot device 1 is kept at 4.2 °K.

Coulomb diamonds 30, $30_1$, $30_2$ are observed, which exhibit a Coulomb gap 31 of $V_C \sim 12.5$ mV and a periodicity 31 of $\Delta V_{G4} = 220$ mV.

The size of the Coulomb gap 31 is large compared with the size of the Coulomb gap in devices (not shown) which comprise only the single electron transistor, i.e. without the isolated quantum dot system. Therefore, the source-drain current $I_D$ through the single electron transistor 3 appears to be suppressed due to the presence of the isolated quantum dot system 2.

Current suppression becomes more evident in a region 33 between -5 V < $V_{G4}$ < - 3.2 V. This is not a linear transport regime, i.e. one in which current flow can be achieved at low source-drain voltages, namely $V_{SD} << e/C_\Sigma$ (where $C_\Sigma$ is the total capacitance of the single electron transistor 3). Instead, it is a regime in which the source-drain bias $V_{SD}$ is increased until a next set of Coulomb diamonds become accessible.

The periodicity 32 of the Coulomb islands 30 remains largely unaltered in this region 32, indicating that not all of the active carriers have been removed from the single electron transistor 3 despite the current suppression.

The total capacitance $C_{\Sigma SET}$ of the single electron transistor 3 can be estimated as $C_{\Sigma SET} = e/V_C = 12.8$ aF.

The capacitance $C_{G4}$ between the fourth gate $4_4$ and the single electron transistor 3 can be estimated as $C_{G4} = e/\Delta V_{G4}$ = 0.73 aF. Thus, a coupling term can be determined as $\alpha_{G4} = C_{G4} / C_{\Sigma SET}$ = 0.057. This agrees well with the value derived from the slopes S1, S2 of Coulomb diamonds $30_1$, $30_2$, namely $\alpha_{G4} = (|S1| + |S2|)^{-1}$ = 0.0568.

It is assumed that direct capacitive coupling between the fourth gate $4_4$ and the isolated quantum dot system 2 is negligible in comparison with direct capacitive coupling between the fourth gate $4_4$ and the single electron transistor 3. Nevertheless, coupling between the isolated quantum dot system 2 and the single electron transistor 3 is significant and may influence the calculation of $\alpha_{G4}$.

In Figure 7b, a second stability diagram in the form of a grey-scale conductance plot 34 is shown. The plot 34 shows measured conductance $\partial I_D / \partial V_{SD}$ as a function of source-drain bias $V_{SD}$ and second gate bias $V_{G2}$ on a logarithmic scale. Different fixed biases are applied to the second gate $4_2$ ranging from -5 to +5 V. While a given fixed bias $V_{G2}$ is applied to the second gate $4_2$ and the other gates $4_1$, $4_3$, $4_4$ are grounded, a bias $V_{SD}$ applied between the source and drain regions $12_1$, $12_2$ (Figure 1) is swept.

Coulomb diamonds 35, $35_1$, $35_2$ are also observed. However, compared with the first conductance plot 29, the second conductance plot 34 shows more complicated structure.

Current is almost completely suppressed for $V_{G2}$ < 0 V. However, there are well-defined periodic Coulomb diamonds $35_1$, $35_2$ in a region 36 between 1 V < $V_{G2}$ < 4 V. In this region 36, a capacitance ratio may be determined as $\alpha_{G2} = C_{G2} / C_{\Sigma SET} = (|S3| + |S4|)^{-1}$ = 0.012.

It is difficult to estimate how much of this ratio is due to direct coupling from the second gate $4_2$. Without the isolated quantum dot system 2, the expected ratio of capacitances (based on device geometry) can be roughly estimated from the inverse of the ratio of the distances of the second and fourth gates $4_2$, $4_4$ from the single electron transistor 3, namely $C_{G2} / C_{G4} \approx (200$ nm $/ 35$ nm$)^{-1}$ = 0.175.

Comparing the expected ratio to the ratio determined experimentally, namely $\alpha_{G2} / \alpha_{G4} = C_{G2} / C_{G4}$ = 0.211, the effective capacitance $C_{G2}$ is larger than expected. This can be explained by the presence of the isolated quantum dot system 2, which effectively acts as a dielectric with a relative permittivity of ~1.2.

As mentioned earlier, direct transport measurements on the isolated quantum dot system 2 cannot be made. However, the single electron transistor 3 can be employed as a sensitive electrometer to detect single electron polarization of the isolated quantum dot system 2.

In Figure 8, first, second and third plots 37, 38, 39 of drain current against gate voltage ($I_D$-$V_{G2}$) are shown. Different biases are applied to the fourth gate 44, namely $V_{G4}$ = -4.82 V, $V_{G4}$ = -4.83 V and $V_{G4}$ = -4.84 V. A given fixed bias is applied to the fourth gate $4_4$, the first and third gates $4_1$, $4_3$ are grounded, a fixed bias is applied between the source and drain bias, namely $V_{SD}$ = +2 mV, and the bias applied to the second gate $4_2$ is swept from -5 V to +5 V. Measurements are taken with the isolated quantum dot device 1 cooled to 4.2 °K.

Coulomb oscillations $41_1$, $41_2$ occur in a voltage range 42 between $-1 \leq V_{G2} \leq +4V$. The Coulomb oscillations $41_1$, $41_2$ have a periodicity 43 which is consistent with the periodicity 37 observed in plot 34 (Figure 7b). The presence of the isolated quantum dot system 2 strongly suppresses current outside this range 42 and modulates the peak amplitude.

Smaller polarisation peaks $44_1$, $44_2$ also occur in the voltage range 42. The polarisation peaks $44_1$, $44_2$ have a period 45 about one third that of the Coulomb oscillations $41_1$, $41_2$ and appear to be due to changes in the polarization of the isolated quantum dot system 2.

If the bias $V_{G4}$ applied to the fourth gate $4_4$ is changed slightly, the polarisation peaks $44_1$, $44_2$ are seen to shift less than the Coulomb oscillations $41_1$, $41_2$. This is because the direct coupling between the fourth gate $4_4$ and the single electron transistor 3 is larger than the direct coupling between the fourth gate $4_4$ and the isolated quantum dot system 2.

The spacing 43 of the Coulomb oscillations $41_1$, $41_2$ is $\Delta V_{G2-SET}$ = 1.02 V. From this, a Coulomb gap $V_C$ can be determined as $V_C = \alpha_{G2} \Delta V_{G2-SEF}$ = 12.2 mV. The value of Coulomb gap $V_C$ agrees well with the value 31 observed in conductance plot 29 (Figure 7a).

The Coulomb oscillation $41_1$ exhibits a full width, half maximum (FWHM) 46 of 200 mV. Assuming a regime wherein the separation of the quantised energy levels is much less that the thermal energy which, in turn, is much less that charging energy, i.e. $\Delta E \ll k_B T \ll e^2/C$, the peak can be expected to have a Gaussian shape. Thus, the effective electron temperature $T_{e,SET}^{eff}$ of the single electron transistor 3 can be determined using:

$$T_{e,SET}^{eff} = e\alpha_{G2}\left(FWHM\right)\Big/4.4k_B \qquad (1)$$

Using equation 1 above, the effective electron temperature is determined to be $T_{e,SET}^{eff} = 6.33\mathrm{K}$.

The spacing 45 of the polarisation peaks $44_1$, $44_2$ is $\Delta V_{G2\text{-}IDQD}$ = 320 mV.

Although the amount of direct coupling between the second gate $4_2$ and isolated quantum dot system 2 is unknown, $\alpha_{G2}$ can be used to obtain an estimate of the charging energy of isolated quantum dot system 2 using $E_{C,\ IDQD}$ = $\alpha_{G2} \Delta V_{G2\text{-}IDQD}$ = 3.84 meV. This is likely to be an underestimate, since the coupling between the second gate $4_2$ and isolated quantum dot system 2 is expected to be greater than $\alpha_{G2}$.

The isolated quantum dot system 2 can have an advantage over quantum dot systems which are directly connected to leads in that noise can be reduced. The isolated quantum dot system 2 can also have an advantage over other types of isolated quantum dot systems which are electrostatically defined using surface gates in that it has a better-defined confining potential, lower cross-capacitances and easier coupling of plural isolated quantum dot systems. Thus, the system 2 lends itself to being used in quantum computer as will be described in more detail later.

*Fabrication*

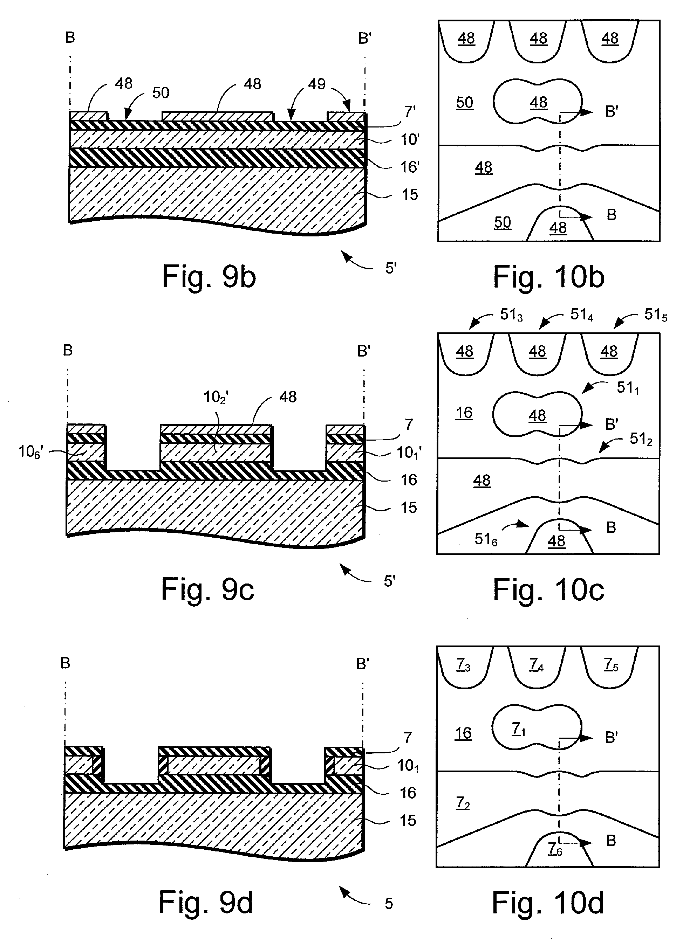

Referring to Figures 9a to 9d and 10a to 10d, a method of fabricating the isolated quantum dot device 1 will now be described:

A silicon-on-insulator substrate 5' is formed by wafer bonding, although other methods may be used, for example, by ion implantation of oxygen ions into a silicon wafer (not shown), annealing and thermally oxidising the wafer. The substrate 5' comprises a silicon substrate portion 15 and overlying layers comprising a silicon dioxide layer 16', a silicon layer 10' and a capping oxide layer 7'. The silicon dioxide layer 16' has a thickness of 400 nm think. The silicon layer 10' is heavily doped with an n-type impurity, in this case phosphorous (P) to a concentration of $2.9 \times 10^{19} \mathrm{cm}^{-3}$, and has a thickness of 40 nm. The capping oxide layer 7' has a thickness of 20 nm. A cross sectional view and a plan view of the corresponding structure are shown in Figures 9a and 10a respectively.

The wafer (not shown) is divided into chips having a size 10 × 10 mm for easier handling. In this example, the device is fabricated on a chip (not shown) from the wafer (not shown).

Ancillary structures may be fabricated. For example, a mesa may be fabricated on which the isolated quantum dot device 1 is formed. Mesas can be used to isolate one device from another and so allow many devices to share a common substrate. Alignment marks and focussing patterns may be fabricated which can be used to help fabricate the isolated quantum dot device 1. In this example, a mesa and alignment marks are fabricated.

The silicon-on-insulator substrate 5' is cleaned using acetone and isopropanol alcohol (IPA) and baked to ensure an upper surface 47 of the substrate 5' is dry. The surface 47 is exposed to hexamethyldisilazaine (HMDS) vapour to ensure that smaller features defined in a subsequently formed optical resist (not shown) stick onto the surface. Optical resist (not shown) is applied to the surface of the substrate and baked to harden the resist. In a contact optical lithography process, the resist (not shown) is selectively exposed to ultraviolet (UV) light from a mercury vapour lamp (not shown) using a mask (not shown). The exposed resist (not shown) is developed in an optical resist developer (not shown) to leave a patterned resist (not shown) which leaves some surfaces of the substrate exposed, in other words clear of resist, and surfaces of the substrate covered by resist.

The exposed surface (not shown) of substrate 5' is etched by reactive ion etching (RIE) using $SiCl_4$ and $CF_4$ as feed gases in equal proportions, at a pressure of 30 mbar and a power of 300 W, which yields an approximate etch rate of 100 nm/min. The resist (not shown) is dissolved in acetone, leaving a mesa (not shown) and alignment marks for a first electron beam lithography stage.

A further, finer set of high-contrast alignment marks (not shown) and focussing patterns (not shown) are defined on the mesa (not shown) to help align subsequent electron beam lithography stages and to help focus electron beams.

The silicon-on-insulator substrate 5' is cleaned using acetone and IPA and baked to ensure the upper surface 47 of the substrate 5' is dry. Polymethylmetacrylate (PMMA) is applied to the surface of the substrate and baked to harden the resist. In a first electron beam lithography process, the resist (not shown) is selectively exposed by scanning an electron beam over portions of the resist. The exposed resist (not shown) is developed in a solution of methylisobutylkeytone (MIBK) and IPA in proportions 1:3 (not shown) to leave a patterned resist (not shown) which leaves surfaces of the substrate exposed, in other words not covered by resist, and surfaces of the substrate covered by resist.

Successive layers of chromium (Cr) and gold (Au) each having a thickness of 30 nm are thermally evaporated onto the patterned resist (not shown). In a so-called "lift-off" process, the resist is dissolved, leaving the alignment marks (not shown) and focussing patterns (not shown) on the previously exposed areas of the substrate.

To define the isolated quantum dot device 1, an etch mask 48 (Figure 9b) is formed.

The silicon-on-insulator substrate 5' is cleaned using acetone and IPA and baked to ensure the upper surface 47 of the substrate 5' is dry. PMMA is applied to the surface of the substrate and baked to harden the resist. In a second electron beam lithography process, the resist (not shown) is selectively exposed by scanning an electron beam over portions of the resist. The exposed resist (not shown) is developed in a solution of 1:3 MIBK and IPA to leave a patterned resist (not shown) which leaves surfaces of the substrate exposed, in other words not covered by resist, and surfaces of the substrate covered by resist.

Aluminium (Al) having a thickness of 30 nm is thermally evaporated at a rate of about 0.1 nms$^{-1}$ and at a pressure of about $1\times10^{-7}$ mbar onto the patterned resist (not shown) and exposed surfaces of the substrate 5'. The aluminium is lift-off to leave an etch mask 48. A cross sectional view and a plan view of the corresponding structure are shown in Figures 9b and 10b respectively.

The etch mask 48 can be examined under a scanning electron microscope to determine whether it is adequately defined and thus proceed further with fabricating the device.

At this point, the etch mask 48 is not connected to the bondpad areas on the mesa. Therefore, a resist etch mask (not shown) is defined to connect these areas together.

The silicon-on-insulator substrate 5' is cleaned using acetone and isopropanol alcohol (IPA) and baked to ensure an upper surface 49 of the substrate 5' and etch mask 48 is dry. Polymethylmetacrylate (PMMA) is applied to the surface of the substrate and baked to harden the resist. In a third electron beam lithography process, the resist (not shown) is selectively exposed by scanning an electron beam over portions of the resist. The exposed resist (not shown) is developed in a solution of methylisobutylkeytone (MIBK) and isopropanol alcohol (IPA) in proportions 1:3 (not shown) to leave a patterned resist (not shown) which leaves surfaces of the substrate exposed and surfaces of the substrate covered by resist.

The pattern of the etch mask 48 and the resist etch mask (not shown) is then transferred to the substrate 5'.

An exposed surface 50 of substrate 5' is etched by RIE using $SiCl_4$ and $CF_4$ as feed gases in equal proportions, at a pressure of 30 mbar and a power of 300 W. The etch depth is 100 nm. The resist etch mask (not shown) is dissolved in acetone, leaving trench isolated regions $51_1$, $51_2$, $51_3$, $51_4$, $51_5$, $51_6$, including etched silicon layer regions $10_1'$, $10_2'$, $10_6'$, which will form the isolated quantum system 2, the single electron transistor 3 and gates $4_1$, $4_2$, $4_3$, $4_4$. A cross sectional view and a plan view of the corresponding structure are shown in Figures 9c and 10c respectively.

The etch mask 48 is removed by selective etching. In this case, the etch mask 48 is dissolved in an alkali optical resist developer.

Exposed etched silicon layer regions $10_1'$, $10_2'$, $10_6'$ are oxidised by heating the substrate 5" in dry oxygen gas to 1000 °C so as to form insulating regions $11_1$, $11_{2A}$, $11_{2B}$, $11_3$, $11_4$, $11_5$, $11_6$, which border conducting regions $10_1$, $10_2$ $10_3$, $10_4$, $10_5$, $10_6$. Oxidation has the advantage of reducing the cross-sectional area of the etched silicon layer regions $10_1'$, $10_2'$, $10_6'$, but also passivating surface states. However, a native, naturally occurring oxide may be used.

Oxidation results in a reduction in the volume of silicon. Coupled with surface depletion effects, this results in a small number of electrically active dopants in each quantum dot and depletes the constriction regions between the dots so as to form tunnel barriers. Oxidation also results in the overall size of the lobe regions increasing from around 50 nm to about 70 nm. The constricted regions need not be depleted. For example, a barrier may be formed by virtue of change in quantisation, for example as described in EP-A-1860600.

To permit electrical connection to the device 1, bond pads (not shown) are defined.

The etched substrate 5" is cleaned using acetone and IPA and baked to ensure an upper surface 47 of the substrate 5' is dry. Optical resist (not shown) is applied to the surface of the substrate and baked to harden the resist. In a contact optical lithography process, the resist (not shown) is selectively exposed to UV light using a mask (not shown). The exposed resist (not shown) is developed in an optical resist developer (not shown) to leave a patterned resist (not shown) which leaves some surfaces of the substrate exposed and surfaces of the substrate covered by resist.

Exposed areas of the substrate 5" are etched using a SILOX etch to remove any native oxide.

Successive layers of chromium (Cr) and gold (Au) having a thickness of 30 nm and 300 nm respectively are thermally evaporated onto the patterned resist (not shown). The chromium and gold is lifted-off, leaving bondpads (not shown) on the previously exposed areas of the substrate 5".

A chip (not shown) on which the device 1 is formed is attached in a chip carrier. Bondwires (not shown) connect bondpads to respective contacts on the chip carrier to enable the device to be connected when placed in a cryostat (not shown) for measurements.

## Isolated quantum dot system arrays

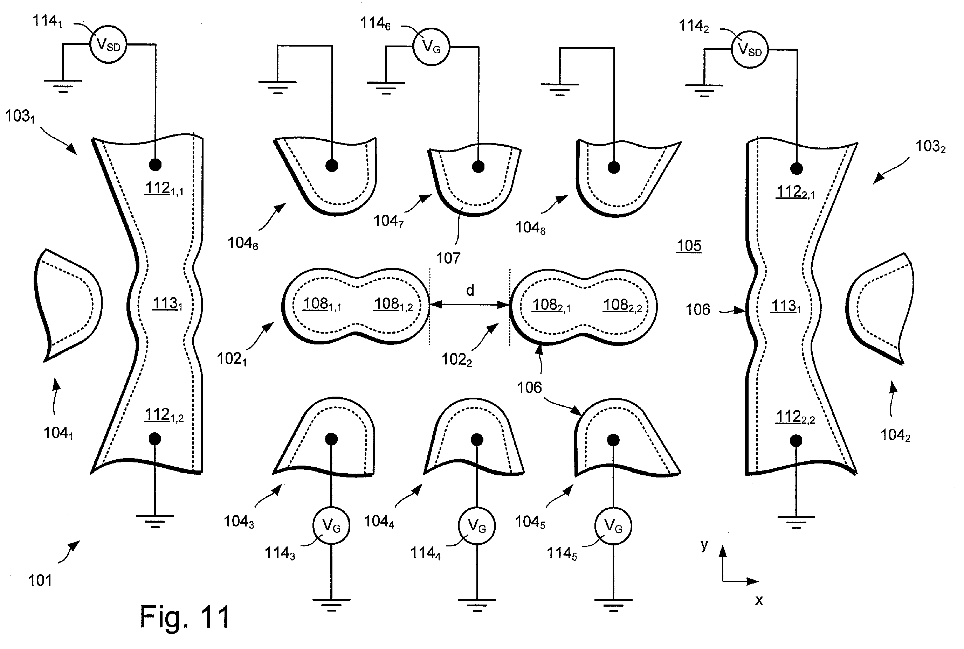

Referring to Figure 11, a first device 101 in accordance with the present invention is shown.

The isolated quantum dot device 101 comprises a first isolated double quantum dot system $102_1$ capacitively coupled to a first single electron transistor $103_1$, a second isolated double quantum dot system $102_2$ capacitively coupled to a second single electron transistor $103_2$. The second isolated double quantum dot system $102_2$ is disposed between the first isolated quantum dot system $102_1$ and the second electrometer $103_1$. Thus, the isolated double quantum dot systems $102_1$, $102_2$ form a $2\times1$ array.

The device 1 also includes a plurality of side gates $104_1$, $104_2$, $104_3$, $104_4$, $104_5$, $104_6$, $104_7$, $104_8$ for controlling

operation of the isolated quantum dot systems $102_1$, $102_2$ and the single electron transistors $103_1$, $103_2$.

The isolated quantum dot systems $102_1$, $102_2$, single electron transistor $103_1$, $103_2$ and side gates $104_1$, $104_2$, $104_3$, $104_4$, $104_5$, $104_6$, $104_7$, $104_8$ are upstanding from a substrate 105, defined by sidewalls 106 and capped by insulating regions 107, in a similar way to the isolated quantum dot device 1 (Figure 1) described earlier. Therefore, description of how the isolated quantum dot systems $102_1$, $102_2$ are defined and shaped will not be repeated. Furthermore, description of how quantum dots (not shown) are formed in each quantum dot systems $102_1$, $102_2$ and how the quantum dots are separated by a tunnel barrier (not shown) will also not be repeated here. Likewise, description of how the single electron transistors $103_1$, $103_2$ are formed will not be repeated.

The first and second lobe regions $108_{1,1}$, $108_{1,2}$, $108_{2,1}$, $108_{2,2}$ each have a diameter of about 40 nm. However, the first and second lobe regions $108_{1,1}$, $108_{1,2}$, $108_{2,1}$, $108_{2,2}$ may have a diameter between 30 and 70 nm. The width and length of the connecting region $109_1$, $109_2$ are each about 20 nm. Thus, each system $102_1$, $102_2$ is about 40 nm wide and about 100 nm long. The first and second lobe regions $108_{1,1}$, $108_{1,2}$, $108_{2,1}$, $108_{2,2}$ need not have the same diameter or may have different shapes so as to produce asymmetry. For example one lobe region may have a diameter d and the other lobe region may have a diameter of up to about 1.5d.

The first and second isolated quantum dot systems $102_1$, $102_2$ are separated by a distance of about 70 nm. However, the separation may be about 40 to 200 nm.

As shown in Figure 11, the isolated quantum dot systems $102_1$, $102_2$ are arranged end-to-end between the single electron transistors $103_1$, $103_2$. Thus, the first single electron transistor $103_1$ is arranged to detect polarization of the first isolated quantum dot system $102_1$ and the second single electron transistor $103_2$ is arranged to detect polarization of the second isolated quantum dot system $102_2$.

The first and second electron transistors $103_1$, $103_2$ have first and second side gates $104_1$, $104_2$ respectively for controlling operation of the transistors $103_1$, $103_2$.

Third, fourth and fifth side gates $104_3$, $104_4$, $104_5$ are arranged in a row on one side of the isolated quantum dot systems $102_1$, $102_2$ and are used for initializing the states of two qubits provided by the two isolated quantum dot systems $102_1$, $102_2$.

Sixth, seventh and eighth side gates $104_6$, $104_7$, $104_8$ are arranged in a row on the opposite side of the isolated quantum dot systems $102_1$, $102_2$ and are used for manipulating the states of the qubits.

The isolated quantum dot device 101 and the devices hereinafter described comprise the same materials as the device 1 (Figure 1) described earlier, e.g. conducting regions formed of doped silicon, and so a description of the materials, impurities, impurity concentrations and variations will not be repeated. The isolated quantum dot systems $102_1$, $102_2$ and the isolated quantum dot systems of the devices hereinafter described have the same dimensions and are separated from the side gates $104_3$, $104_4$, $104_5$ by the same (or similar) dimensions as the device 1 (Figure 1) described earlier, for example by about 30 to 150 nm.

As shown in Figure 11, first and second voltage sources $114_1$, $114_2$ are used to apply biases between source and drain $12_{1,1}$, $12_{1,2}$, $12_{2,1}$, $12_{2,2}$ for the first and second electron transistors $103_1$, $103_2$.

Third, fourth and fifth voltage sources $114_3$, $114_4$, $114_5$ are used to apply gate biases to the third, fourth and fifth side gates $104_3$, $104_4$, $104_5$.

A sixth voltage sources $114_3$ is used to apply radio frequency signal and/or pulses to the seventh side gate $104_7$ for manipulating the isolated quantum dot systems $102_1$, $102_2$. The sixth and eighth side gates $104_6$, $104_8$ are grounded, although further voltage sources may be provided.

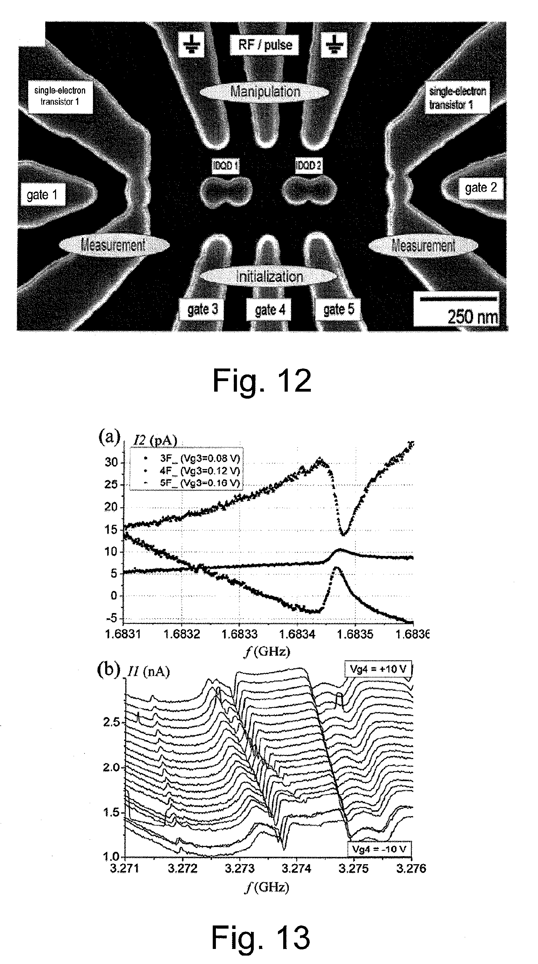

Referring to Figure 12, a scanning electron micrograph of the isolated quantum dot device 101 is shown.

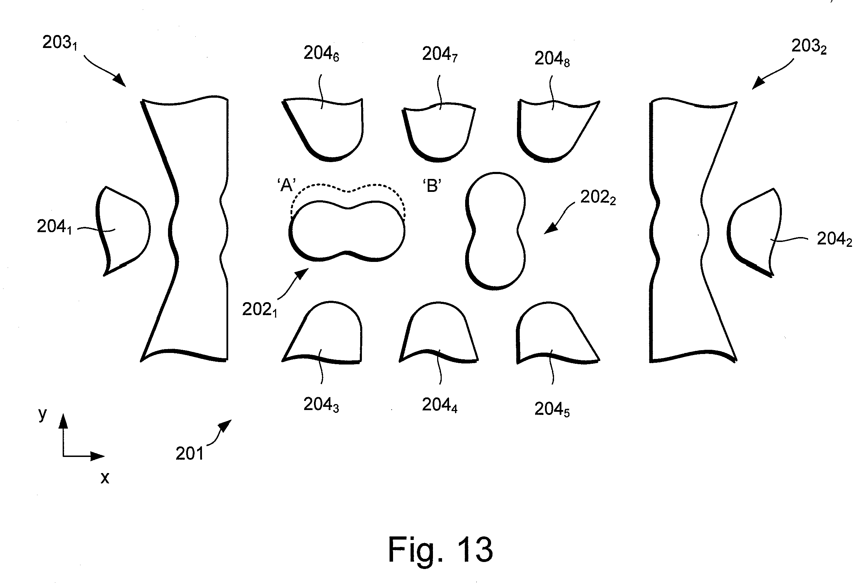

Referring to Figures 13a and 13b, electrical characteristics of the isolated quantum dot device 101 are shown.

The same method is used to fabricate the device 101 as the method used to fabricate the device 1 described earlier. Therefore, a description of the method will not be repeated.

Referring to Figure 13, a second device 201 in accordance with the present invention is shown.

The second device 201 is the same as the first device 101 (Figure 11) except that first and second isolated double quantum dot system $202_1$, $202_2$ are arranged perpendicularly or "end-to-side", rather than in-line, in parallel or "end-to-end". The first and second isolated double quantum dot system $202_1$, $202_2$ need not be perpendicular (i.e. arranged at about 90°) but can be arranged, for example at an angle within a range of about 45° to 90°. Additionally or alternatively, the first or second isolated double quantum dot system $202_1$, $202_2$ may be offset in the y-direction (for example as shown in chain in Figure 13).

The first isolated double quantum dot system $202_1$ is capacitively coupled to a first single electron transistor $203_1$ and the second isolated double quantum dot system $202_2$ is capacitively coupled to a second single electron transistor $203_2$.

The first and second electron transistors $203_1$, $203_2$ have first and second side gates $204_1$, $204_2$ respectively for controlling operation of the transistors $203_1$, $203_2$.

Third, fourth and fifth side gates $204_3$, $204_4$, $204_5$ are arranged in a row on one side of the isolated quantum dot systems $202_1$, $202_2$ and are used for initializing the states of two qubits provided by the two isolated quantum dot

systems $202_1$, $202_2$.

Sixth, seventh and eighth side gates $204_6$, $204_7$, $204_8$ are arranged in a row on the opposite side of the isolated quantum dot systems $202_1$, $202_2$ and are used for manipulating the states of the qubits.

As explained earlier, the isolated quantum dot device 201 comprises the same materials as the device 1 (Figures 1 & 2) described earlier.

Orthogonally-arranged double isolated quantum dot systems $202_1$, $202_2$ can have an advantage that they can be independently addressed using first and second orthogonally-orientated electric fields $E_x$, $E_y$ respectively.

The electric fields can be applied using the side gates $204_3$, $204_4$, $204_5$ or using an external source (not shown).

In other embodiments of the invention comprising a plurality of isolated double quantum dot systems, the isolated double quantum dot systems may be aligned along one of two (or more) different orientations. The orientations need not be perpendicular. This can be used for selectively addressing different groups of qubits, for example, labelled type-A qubits and type-B qubits. Qubits may be arranged in the array periodically in one or both dimensions, e.g. ABAB..., ABBABB... or AABBAABB..., or aperiodically in one or both dimensions, for example ABBBBAAB.

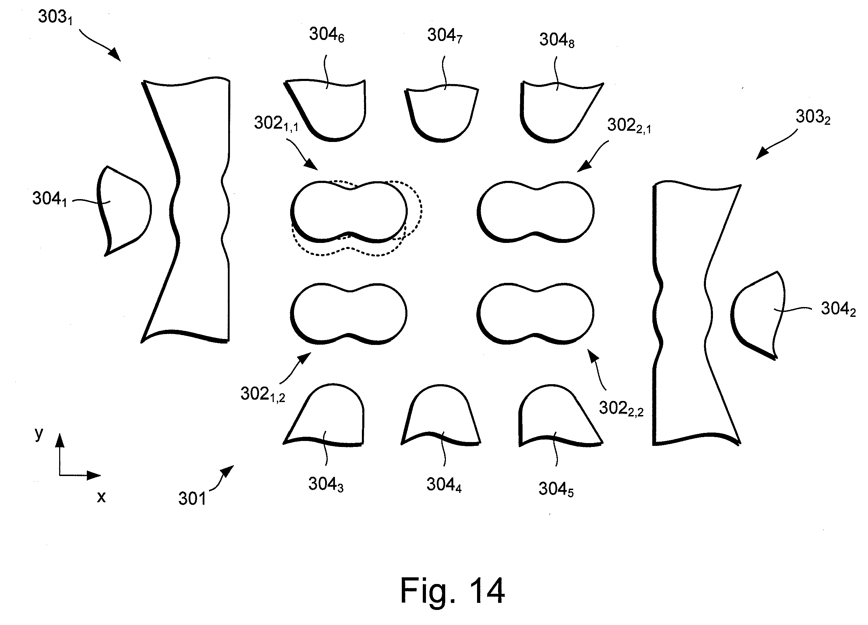

Referring to Figure 14, a third device 301 in accordance with the present invention is shown.

The third device 301 is the same as the first device 101 (Figure 11) except that (a) the device 301 comprises four isolated double quantum dot systems $302_{1,1}$, $302_{2,1}$, $302_{1,2}$, $302_{2,2}$ arranged to form a $2 \times 2$ array and (b) single electron transistors $303_1$, $303_2$ are offset to measure the polarization of the first isolated double quantum dot systems $302_{1,1}$ in the array, and the fourth isolated double quantum dot systems $302_{2,2}$ in the array. In some embodiments, the qubits all have the same properties, i.e. the qubits are all of type A.

The first and second electron transistors $303_1$, $303_2$ have first and second side gates $304_1$, $304_2$ respectively for controlling operation of the transistors $303_1$, $303_2$.

Third, fourth and fifth side gates $304_3$, $304_4$, $304_5$ are arranged in a row on one side of the isolated quantum dot systems $302_{1,1}$, $302_{2,1}$, $302_{1,2}$, $302_{2,2}$ and are used for initializing the states of the qubits provided by the two isolated quantum dot systems $302_{1,1}$, $302_{2,1}$, $302_{1,2}$, $302_{2,2}$.

Sixth, seventh and eighth side gates $304_6$, $304_7$, $304_8$ are arranged in a row on opposite outermost sides of the array and are used for manipulating the states of the qubits.

If will be appreciated that four electrometers, e.g. single-electron transistors, may be provided to measure the polarization of each isolated quantum dot systems $302_{1,1}$, $302_{2,1}$, $302_{1,2}$, $302_{2,2}$.

One or more of the isolated double quantum dot systems $302_{1,1}$, $302_{2,1}$, $302_{1,2}$, $302_{2,2}$, may be offset in x- and/or y-directions (for example as shown in chain in Figure 14).

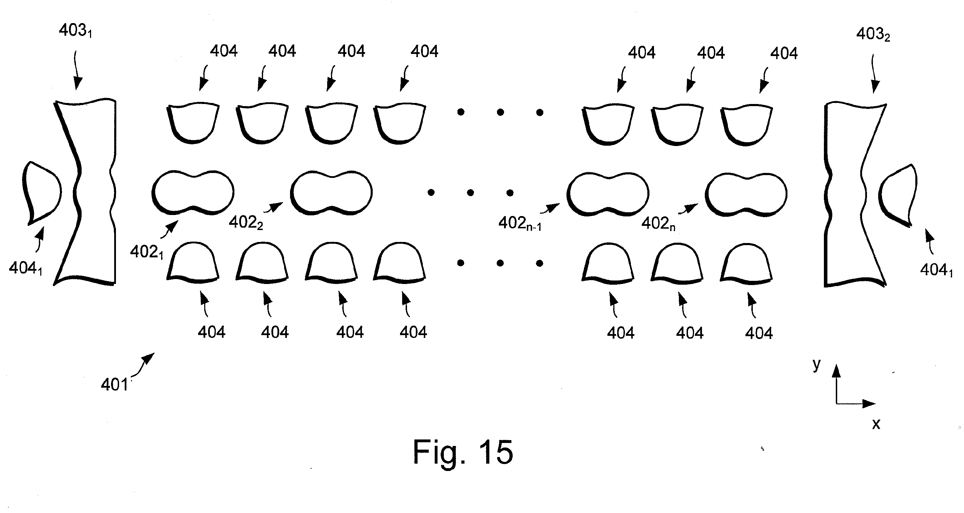

Referring to Figures 15, 16, 17, 18 and 19, further embodiments of the present invention is shown.

These further embodiments are similar to the previously-described embodiments of the invention, differing mainly in the number and arrangement of the isolated quantum dot systems. However, these embodiments comprise the same materials as the device 1 (Figures 1 & 2) described earlier, e.g. conducting regions formed of doped silicon, and so a description of the materials, impurities, impurity concentrations and variations will not be repeated. The isolated quantum dot systems have the same dimensions and are separated from the side gates by the same (or similar) dimensions as the device 1 (Figure 1) described earlier.

Likewise, the devices are operated in a similar way. This includes cooling the sample in, for example, a dilution refrigerator, to temperatures of the order of a few tens or hundreds or milliKelvin.

Referring in particular to Figure 15, a fourth device 401 in accordance with the present invention includes an $n \times 1$ array of isolated double quantum dot systems $402_1$, $402_2$,..., $402_n$ (where n is an integer greater than 2). The device 401 includes two side gates $404_1$, $404_2$ for the single electron transistors $403_1$, $403_2$ and a further $6+(4 \times (n-2))$ side gates 404, divided into two equally-spaced sets either side of the isolated double quantum dot systems $402_1$, $402_2$,..., $402_n$ for initializing and manipulating the qubits. It will be appreciated that a different number of gates may be used and that they may be differently arranged.

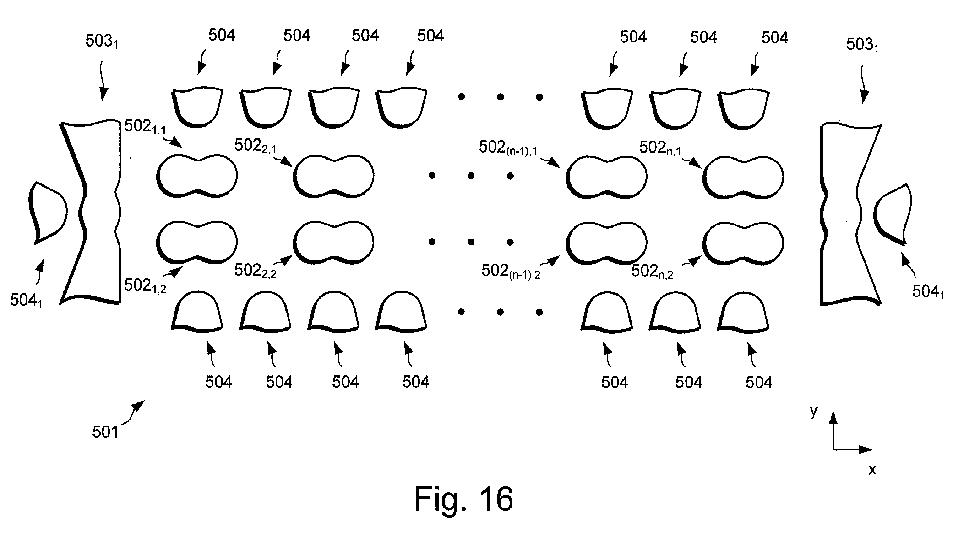

Referring in particular to Figure 16, a fifth device 501 in accordance with the present invention includes an $n \times 2$ array of isolated double quantum dot systems $502_{1,1}$, $502_{1,2}$,..., $502_{2,n}$ (where n is an integer greater than 2). The device 501 includes two side gates $504_1$, $504_2$ for the single electron transistors $503_1$, $503_2$ and a further $6+(4 \times (n-2))$ side gates, divided into two equally-spaced sets either side of the isolated double quantum dot systems $502_1$, $502_2$,..., $502_n$ for initializing and manipulating the qubits.

In this example, as shown in Figure 16, the first single electron transistor $503_1$ is equidistant from the isolated double quantum dot systems $502_{1,1}$, $502_{2,1}$ in a first column (e.g. left-most column) of the $n \times 2$ array. Thus, the electron transistor $503_1$ measures net polarization of the first two isolated double quantum dot systems $502_{1,1}$, $502_{2,1}$. Likewise, the second single electron transistor $503_2$ is equidistant from the isolated double quantum dot systems $502_{1,n}$, $502_{2,n}$ in a n-th column of the $n \times 2$ array (e.g. right-most column). It will be appreciated that a different number of gates may be used and that they may be differently arranged.

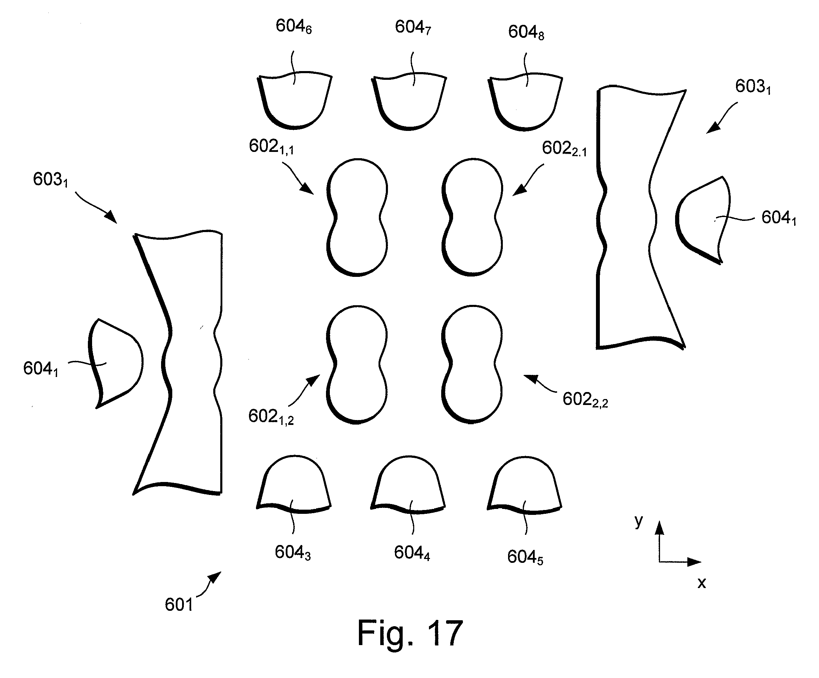

Referring in particular to Figure 17, a sixth device 601 in accordance with the present invention includes an $2 \times 2$ array of isolated double quantum dot systems $602_{1,1}$, $602_{1,2}$, $602_{2,1}$, $602_{2,2}$.

The sixth device 601 differs from the third device 30 in that the isolated double quantum dot systems $602_{1,1}$, $602_{1,2}$, $602_{2,1}$, $602_{2,2}$ are arranged side-by-side.

The device 601 comprises a first isolated double quantum dot system $602_1$ capacitively coupled to a first single electron transistor $603_1$, a second isolated double quantum dot system $602_2$ capacitively coupled to a second single electron transistor $603_2$.

The first and second electron transistors $603_1$, $603_2$ have first and second side gates $604_1$, $604_2$ respectively for controlling operation of the transistors $603_1$, $603_2$.

Third, fourth and fifth side gates $604_3$, $604_4$, $604_5$ are arranged in a row on one side of the isolated quantum dot systems $602_1$, $602_2$ and are used for initializing the states of two qubits provided by the two isolated quantum dot systems $602_1$, $602_2$.

Sixth, seventh and eighth side gates $604_6$, $604_7$, $604_8$ are arranged in a row on the opposite side of the isolated quantum dot systems $602_1$, $602_2$ and are used for manipulating the states of the qubits.

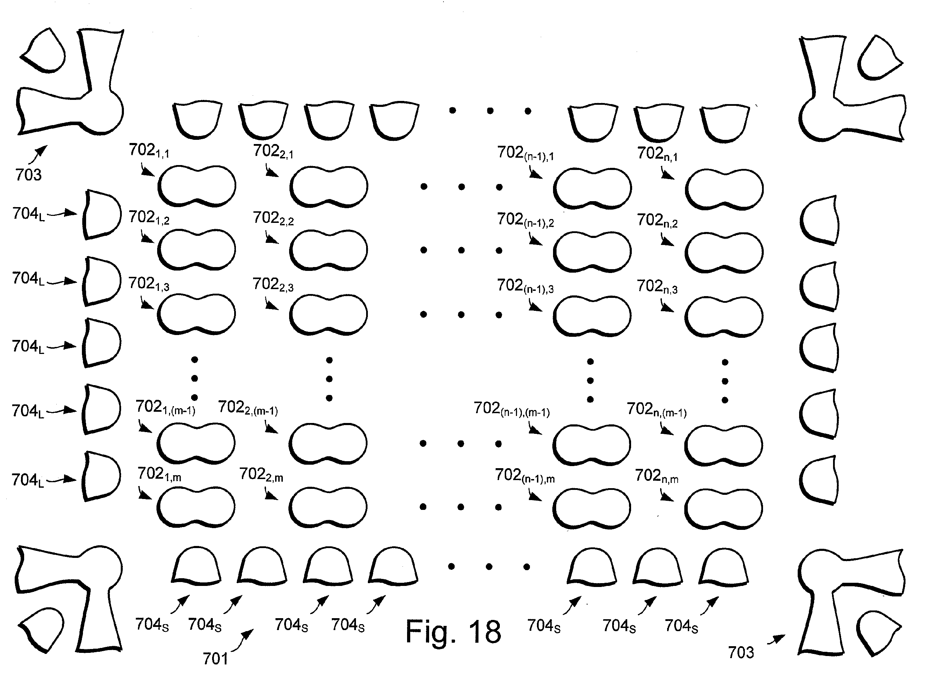

Referring in particular to Figure 18, a seventh device 701 in accordance with the present invention includes an $n \times m$ array of isolated double quantum dot systems $702_{1,1}$, $702_{1,2}$,..., $702_{n,m}$ (where $n$ and $m$ are integers greater than 2 and $n = m$ or $n \neq m$).

The device 701 includes four single electron transistor 703 arranged to measure the states of the (1, 1), (n,1), (m, 1) and (n, m) elements in the array.

The device includes side gates $704_S$ arranged in a row on either side of the array for controlling, among other things, interactions between columns of isolated double quantum dot systems.

The device may include further side gates $704_L$ arranged in a column on either side of the array for controlling, among other things, interactions between rows of isolated double quantum dot systems.

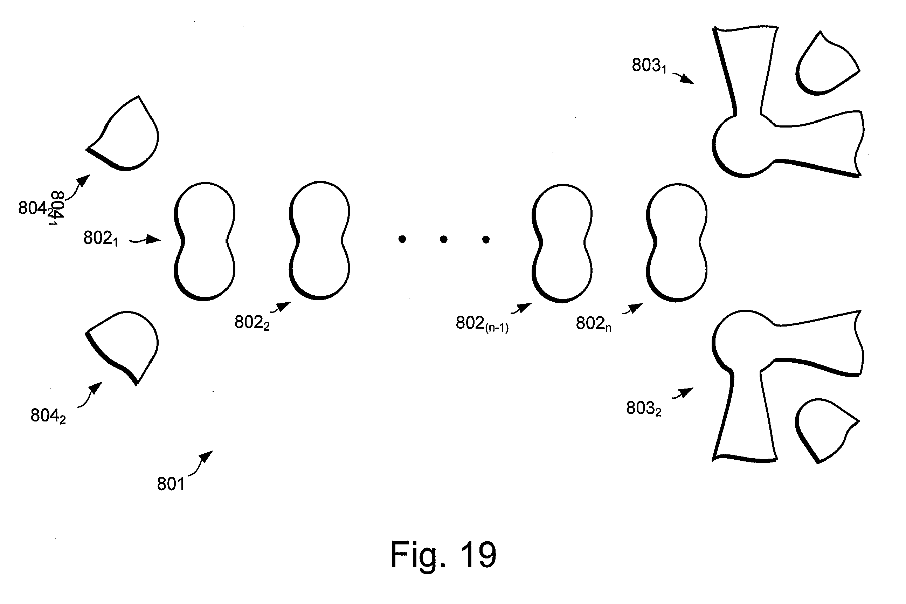

Referring to in particular to Figure 19, an eighth device 801 in accordance with the present invention includes an $n \times 1$ array of isolated double quantum dot systems $802_1$, $802_2$,..., $802_{2n}$ (where $n$ is an integer greater than 2). The device 801 is similar to device 401 expect that (a) isolated double quantum dot systems $802_1$, $802_2$, $802_3$, $802_4$ are arranged side-by-side and (b) a different configuration of single electron transistors $803_1$, $803_2$ and side gates $804_1$, $804_2$ are used.

In the embodiments hereinbefore described, each device includes an array of two or more isolated double quantum dot systems. Using an array of devices can help not only to carry out more complex quantum information processing operations, but also to decouple qubits from single-electron transistors and/or sources of noise. For example, operating the single-electron transistors can affect charge distribution on the quantum dots and, thus, introduce decoherence.

It is possible to include isolated conductive elements in an array which do not necessarily play an active part during quantum information computing, but can allow states to be initialised and/or measured while providing benefit of a quieter electromagnetic environment. This can help to maintain coherence longer and, thus, more operations to be performed before coherence is lost.

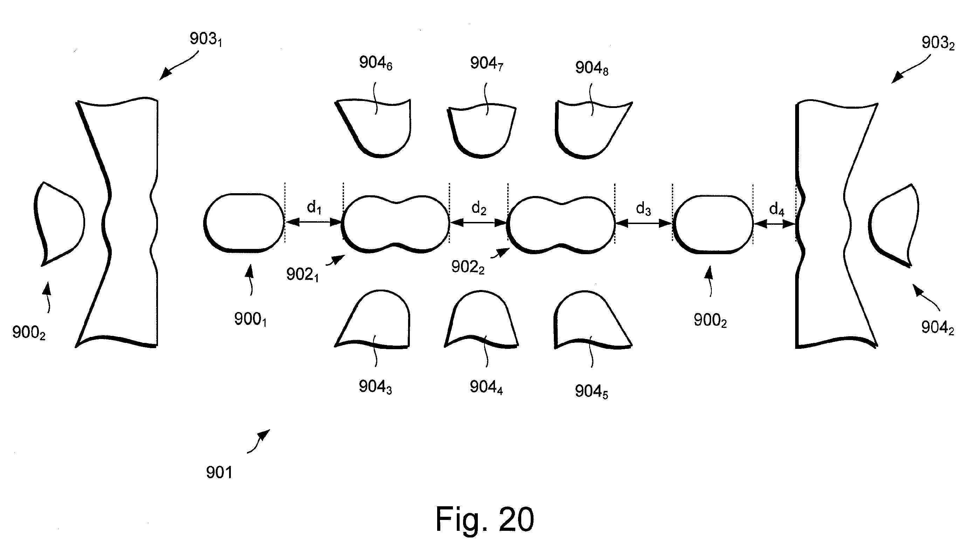

Referring to Figure 20, a ninth device 901 in accordance with the present invention is shown.

The ninth device 901 is the same as the first device 101 except that isolated conductive elements $900_1$, $900_2$ are included between the first and second isolated double quantum dot system $902_1$, $902_2$ and the single-electron transistors $903_1$, $1003_2$.

Thus, the first isolated double quantum dot system $902_1$ is capacitively coupled to the first isolated conductive elements $900_1$ which in turn is capacitively coupled to the first single electron transistor $903_1$. Likewise, the second the first isolated conductive elements $900_2$ which in turn is capacitively coupled to the second single electron transistor $903_2$.

The first and second electron transistors $903_1$, $903_2$ have first and second side gates $1004_1$, $1004_2$ respectively for controlling operation of the transistors $903_1$, $903_2$,

Third, fourth and fifth side gates $904_3$, $904_4$, $904_5$ are arranged in a row on one side of the isolated quantum dot systems $902_1$, $902_2$ and are used for initializing the states of two qubits provided by the two isolated quantum dot systems $902_1$, $902_2$.

Sixth, seventh and eighth side gates $904_6$, $904_7$, $904_8$ are arranged in a row on the opposite side of the isolated quantum dot systems $902_1$, $902_2$ and are used for manipulating the states of the qubits.

The isolated conductive elements $900_1$, $900_2$ each have a diameter of about 40 nm and a length of about 100 nm. However, the isolated conductive elements $900_1$, $900_2$ may have a diameter between 30 and 70 nm and a length between 50 and 150 nm. The isolated conductive elements $900_1$, $900_2$ need not exhibit quantised states and/or charging effects.

Each isolated conductive elements $900_1$, $900_2$ is separated from an isolated double quantum dot system $902_1$, $902_2$ and from a single electron transistor $903_1$, $903_2$ by about 70 nm, i.e. $d_3 = d_4$. However, the separation may be about 10 to 500 nm. Preferably, the separation is about 200 to 300 nm or more so as to reduce noise when then single electron transistor $903_1$, $903_2$ is operated. Furthermore, the isolated conductive elements $900_1$, $900_2$ may be placed closer to the isolated double quantum dot system $902_1$, $902_2$ than the a single electron transistor $903_1$, $903_2$ or vice

versa, i.e. $d_3 \neq d_4$.

The isolated conductive elements $900_1$, $900_2$ are formed in substantially the same way as the isolated quantum dot systems $902_1$, $902_2$, e.g. formed from silicon bounded by silicon dioxide. However, the isolated conductive elements $900_1$, $900_2$ are not shaped (e.g. dumb-bell shaped) and/or dimensioned so as to form a double quantum dot system.

It will be appreciated that isolated conductive elements maybe used in arrays of any number of elements. An isolated conductive element may be used not only to separate isolated quantum dot systems from a single electron transistor, but also to separate isolated quantum dot systems. For example, they may be used to couple different devices together.

It will be appreciated that many modifications may be made to the embodiments hereinbefore described.

For example, different isolated double quantum dot systems in the same array may be individually addressed in other ways by varying resonant properties the systems. This may be achieved by selectively varying doping concentrations, for example by using scanning ion implantation, varying the dimensions of the isolated double quantum dot systems and/or by varying dimensions of the coupling regions.

As explained earlier, the isolated quantum dot systems may be selectively brought closer together or separated so as change coupling. Different types of qubits may be arranged periodically, e.g. ABABAB..., etc. The arrays need not be periodic in separation or qubit type. Separation periodicity and type periodicity may vary within the array in one or both dimensions, i.e. row and/or columns.

As explained earlier, isolated quantum dot systems may be asymmetric. The isolated quantum dot systems need not be orientated parallel or perpendicular to each other and/or the array need not be arranged with rows and columns perpendicular to each other.

It will be appreciated that a modification, such as a change in separation or doping concentration, in relation to one of the embodiments hereinbefore described may also be made to the other embodiments.

Other forms of electrometer may be used instead of single-electron transistors.

**Claims**

1. A quantum information processing device including:

   an isolated double quantum dot system;
   an electrometer; and
   an isolated conductive element disposed between the isolated quantum dot system and the electrometer for coupling the isolated quantum dot system and the electrometer.

2. A device according to claim 1, wherein the isolated conductive element comprises a region of semiconducting material.

3. A device according to claim 2, wherein the semiconducting material comprises silicon.

4. A device according to claim 3, wherein the semiconducting material is intrinsic or is doped with an impurity having an impurity concentration of at least $1 \times 10^{18}$ cm$^{-3}$.

5. A device according to any preceding claim, wherein the isolated conductive element is arranged as an elongate bar.

6. A device according to any preceding claim, wherein the isolated conductive element is arranged is arranged to exhibit Coulomb blockade.

7. A device according to any preceding claim, wherein the isolated conductive element is arranged is arranged to exhibit quantised states.

8. A device according to any preceding claim, wherein the isolated conductive element is a double quantum dot system.

9. A device according to any preceding claim, wherein the isolated conductive element is formed in a layer having a thickness equal to or less than about 100 nm, preferably equal to or less than about 50 nm.

10. A device according to any preceding claim, wherein the isolated conductive element is elongate and has a longitudinal dimension equal to or less than about 100 nm.

**11.** A device according to claim 10, wherein the isolated conductive element is elongate and has a first, transverse dimension equal to or less than about 50 nm.

**12.** A device according to claim 9 or 10, wherein the isolated conductive element is elongate and has a second, transverse dimension equal to or less than about 50 nm.

**13.** A device according to claim 12, wherein the second, transverse dimension corresponds to a layer thickness.

**14.** A device according to any preceding claim, wherein the isolated double quantum dot system and the isolated conductive element are separated by a gap equal to or less than about 200 nm, preferably equal to or less than about 100 nm.

**15.** A device according to any preceding claim, wherein the isolated double quantum dot system and the isolated conductive element are separated by a gap equal to or more than about 10 nm, preferably equal to or more than about 40 nm.

**16.** A device according to any preceding claim, wherein the electrometer and the isolated conductive element are separated by a gap equal to or less than about 500 nm, preferably between about 200 nm and 300 nm.

**17.** A device according to any preceding claim, wherein the isolated double quantum dot system comprises a region of semiconducting material.

**18.** A device according to claim 17, wherein the semiconducting material is silicon.

**19.** A device according to claim 17 or 18, wherein the semiconducting material is intrinsic or is doped with an impurity having an impurity concentration of at least $1 \times 10^{18}$ cm$^{-3}$.

**20.** A device according to any preceding claim, wherein the isolated double quantum dot system is bilobate having first and second lobes.

**21.** A device according to any preceding claim, wherein isolated double quantum dot system is arranged is arranged to exhibit Coulomb blockade.

**22.** A device according to any preceding claim, comprising:

an array of isolated double quantum dot systems; and
at least one electrometer for determining charge distribution on at least one isolated double quantum dot system.

**23.** A device according to claim 22, wherein each isolated double quantum dot system is bilobate having first and second lobes.

**24.** A device according to claim 23, wherein isolated double quantum dot systems which are adjacent to each other in a row or column are arranged perpendicularly to each other.

**25.** A device according to claim 24, wherein isolated double quantum dot systems which are adjacent to each other in a row are arranged perpendicularly to each other and isolated double quantum dot systems which are adjacent to each other in a column are arranged in parallel or *vice versa*.

**26.** Apparatus comprising:

a device according to any preceding claim;
a radio frequency signal source; and
an antenna coupled to the source; the source and antenna arranged so as to excite the or each isolated double quantum dot system.

**27.** Apparatus comprising:

a device according to any preceding claim;

a refrigerator for cooling the device to a temperature equal to or less than 4.2 °K.

Fig. 1

Fig. 2

Fig. 3

Fig. 4

Fig. 6a

Fig. 6b

Fig. 5

Fig. 7a

Fig. 7b

Fig. 8

Fig. 9a

Fig. 10a

Fig. 9b

Fig. 10b

Fig. 9c

Fig. 10c

Fig. 9d

Fig. 10d

21

Fig. 11

Fig. 12

Fig. 13

Fig. 13

EP 2 075 745 A1

Fig. 14

Fig. 15

EP 2 075 745 A1

Fig. 16

Fig. 17

$604_6$    $604_7$    $604_8$

$603_1$

$602_{1,1}$    $602_{2.1}$

$604_1$

$603_1$

$604_1$

$602_{1,2}$    $602_{2,2}$

$604_3$    $604_4$    $604_5$

$601$

y

x

EP 2 075 745 A1

Fig. 18

Fig. 19

Fig. 20

EP 2 075 745 A1

**European Patent Office**

## EUROPEAN SEARCH REPORT

Application Number

EP 07 12 4170

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,X | EP 1 262 911 A (HITACHI EUROP LTD [GB]) 4 December 2002 (2002-12-04) | 1-23,26, 27 | INV. G06N1/00 |
| Y | * paragraph [0100] - paragraph [0101] * <br> * paragraph [0106] - paragraph [0114] * <br> * paragraph [0023]; figure 16 * <br> ----- | 24,25 | |
| Y | EP 1 860 600 A (HITACHI LTD [JP]) 28 November 2007 (2007-11-28) <br> * paragraph [0108] - paragraph [0112]; figure 15 * <br> ----- | 24,25 | |

**TECHNICAL FIELDS SEARCHED (IPC)**

G06N

The present search report has been drawn up for all claims

| Place of search | Date of completion of the search | Examiner |
|---|---|---|
| The Hague | 20 May 2008 | Schenkels, Paul |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

# EP 2 075 745 A1

## ANNEX TO THE EUROPEAN SEARCH REPORT
## ON EUROPEAN PATENT APPLICATION NO.

EP 07 12 4170

This annex lists the patent family members relating to the patent documents cited in  the above-mentioned European search report.
The members are as contained in the European Patent Office EDP file on
The European Patent Office is in no way liable for these particulars which are merely given for the purpose of information.

20-05-2008

| Patent document cited in search report | | Publication date | Patent family member(s) | | Publication date |
|---|---|---|---|---|---|
| EP 1262911 | A | 04-12-2002 | JP | 2003086788 A | 20-03-2003 |
| | | | US | 2002190249 A1 | 19-12-2002 |
| EP 1860600 | A | 28-11-2007 | NONE | | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1262911 A

- EP 1860600 A

**Non-patent literature cited in the description**

- **E. G. EMIROGLU ; D. G. HASKO ; D. A. WILLIAMS.** Isolated double quantum dot capacitively coupled to a single quantum dot single-electron transistor in silicon. *Applied Physics Letters,* 2003, vol. 83, 3942

- **J. GORMAN ; D. G. HASKO ; D. A. WILLIAMS.** Charge-Qubit Operation of an Isolated Double Quantum Dot. *Physical Review Letters,* 2005, vol. 95, 090502